# EUROPEAN PATENT SPECIFICATION

(11) **EP 4 044 207 B1**
(45) Date of publication and mention of the grant of the patent: **10.04.2024**
(21) Application number: 20891839.1
(22) Date of filing: 29.10.2020
(51) Int. Cl.: H01H 13/04, H01H 13/14, H04M 1/23, H05K 5/02, G06F 1/16

(54) **ELECTRONIC DEVICE**
ELEKTRONISCHE VORRICHTUNG
DISPOSITIF ÉLECTRONIQUE

(30) Priority: 26.11.2019 CN 201911172810
(43) Date of publication of application: 17.08.2022
(73) Proprietor: Honor Device Co., Ltd., Shenzhen, Guangdong 518040 (CN)
(72) Inventor: WANG, Yuan, Shenzhen, Guangdong 518040 (CN); YAO, Wenxing, Shenzhen, Guangdong 518040 (CN); WANG, Xuyang, Shenzhen, Guangdong 518040 (CN)
(74) Representative: Epping - Hermann - Fischer
(86) International application number: PCT/CN2020/124754
(87) International publication number: WO 2021/103911

(56) References cited:
- CN-A- 102 136 382
- CN-A- 108 231 462
- CN-A- 110 047 675
- CN-A- 110 365 830
- CN-A- 110 970 248
- US-A1- 2017 118 319
- US-A1- 2019 080 860

## Description

### TECHNICAL FIELD

The present invention relates to the field of electronic device technologies, and in particular, to an electronic device.

### BACKGROUND

Buttons are common parts for inputting information and instructions and switching states in electronic devices. Therefore, effectiveness of buttons becomes the most basic key point to be considered during design of button structures. However, existing button structures are simply fixed in electronic devices, the button structures are not stable, and after long-term use of the electronic devices, buttons are quite prone to failure, which affects user experience.

Documents US 2019/0080860 A1 and US 2017/0118319 A1 relate to electronic devices including a key module.

### SUMMARY

This application provides an electronic device, to improve assembly stability of buttons in the electronic device, ensure long-term use effectiveness of the buttons, and improve user experience.

The electronic device provided in this application includes a middle frame, a switch member, a pressing member, and a fixing member, where the middle frame includes an external face and an assembly face connected to the external face, the middle frame is provided with a mounting slot and a button slot, an opening of the mounting slot is located on the assembly face, an opening of the button slot is located on the external face, and the button slot communicates with the mounting slot;
the switch member is mounted in the mounting slot, the switch member includes a circuit board and a switch fixed to the circuit board, and the circuit board includes a first limiting part; the pressing member includes a pressing part, and a pushing part and a clamping part that are connected to the pressing part, the pushing part and the clamping part extend from the button slot into the mounting slot, the pushing part faces toward the switch, and the pressing part is partially exposed on the external face of the middle frame; and the fixing member is located in the mounting slot, the fixing member includes a fixing plate, and an engaging plate and a first stop plate that are connected to the fixing plate, the fixing plate is fixedly connected to a slot bottom wall and/or a slot side wall of the mounting slot, the engaging plate clamps the clamping part, the first stop plate is located on a side of the first limiting part away from the slot bottom wall of the mounting slot, and the first stop plate faces toward the first limiting part, wherein a distance between two faces of the first stop plate and the first limiting part that face toward each other is less than or equal to 0.1 mm.

In the electronic device shown in this application, the first stop plate of the fixing member faces toward the first limiting part or abuts against the first limiting part. When the electronic device is used for a long time or drops by accident, the first stop plate limits the first limiting part to move in a direction leaving the slot bottom wall of the mounting slot, so that the switch member is always limited in the mounting slot and does not fall off the mounting slot easily. This improves assembly stability of the switch member in the electronic device. When a user presses the pushing part, the pushing part can always abut against the switch of the switch member to trigger the switch. This ensures effectiveness of each press on the pushing part by the user and improves user experience. It may be understood that, due to tolerance of the first stop plate and the first limiting part during production or assembly, provided that the distance between the two faces of the first stop plate and the first limiting part that face toward each other less than or equal to 0.1 mm, it may be considered that the first stop plate has effectively limited the first limiting part in the Z-axis direction.

That the pushing part faces toward the switch means that at least part of the pushing part directly faces toward the switch.

That the first stop plate faces toward the first limiting part means that at least part of the first stop plate directly faces toward the first limiting part, so as to limit the first limiting part to move in a direction leaving the slot bottom wall of the mounting slot.

In an implementation, the circuit board includes a reinforcing plate and a flexible circuit board, the reinforcing plate includes the first limiting part, the circuit board is mounted on a surface of the reinforcing plate, and the first limiting part is exposed.

In an implementation, the mounting slot is recessed from the assembly face in a Z-axis direction, the first stop plate limits the first limiting part to move in the Z-axis direction, that is, the fixing member limits the first limiting part in the Z-axis direction through the first stop plate. The Z-axis direction is a thickness direction of the electronic device.

In an implementation, the slot side wall of the mounting slot includes a first slot side wall and a second slot side wall that face toward each other, where the fixing plate is fixedly connected to the first slot side wall, the second slot side wall is partially recessed to form a clamping slot, the first stop plate partially protrudes to form a clamping protrusion, and the clamping protrusion is embedded in the clamping slot, so as to limit the first stop plate to move in a direction leaving the slot bottom wall of the mounting slot to enable the first stop plate to always face toward or abut against the first limiting part, and limit the first limiting part to move in a direction leaving the slot bottom wall of the mounting slot to limit the first limiting part in the mounting slot. This improves assembly stability of the switch member in the mounting slot and prevents the first limiting part from falling off the mounting slot.

In an implementation, the first stop plate partially protrudes to form a limiting protrusion, the limiting protrusion includes an end face facing toward the slot bottom wall of the mounting slot, and the end face faces toward the first limiting part or abuts against the first limiting part, so as to increase a limiting width of the first stop plate on the first limiting part. When the first limiting part moves in a direction leaving the second slot side wall, the limiting protrusion can still limit the first limiting part to move in a direction leaving a slot bottom face of the mounting slot, so that the first limiting part is always limited in the mounting slot. This improves assembly stability of the switch member in the mounting slot and prevents the switch member from falling off the mounting slot.

The limiting protrusion protrudes from the first stop plate in a direction leaving the second slot side wall.

That the end face of the limiting protrusion faces toward the first limiting part means that at least part of the end face of the limiting protrusion directly faces toward the first limiting part, and that the end face of the limiting protrusion abuts against the first limiting part means that the end face of the limiting protrusion is in contact with the first limiting part, so as to limit the first limiting part to move in a direction leaving the slot bottom wall of the mounting slot.

In an implementation, a periphery of the first stop plate is bent and extends to form a limiting plate, the limiting plate includes a limiting face facing toward the slot bottom wall of the mounting slot, and the limiting face faces toward the first limiting part or abuts against the first limiting part, so as to increase a limiting width of the first stop plate on a first limiting plate. When the first limiting part moves in a direction leaving the second slot side wall, the limiting plate can still limit the first limiting part to move in a direction leaving a slot bottom face of the mounting slot, so that the first limiting part is always limited in the mounting slot. This improves assembly stability of the switch member in the mounting slot and prevents the switch member from falling off the mounting slot.

In an implementation, the slot side wall of the mounting slot further includes a third slot side wall and a fourth slot side wall that are connected between the first slot side wall and the second slot side wall, the fixing member includes a first end face and a second end face that face away from each other, and the first end face faces toward or abuts against the third slot side wall, and the second end face faces toward or abuts against the fourth slot side wall, so as to limit the fixing member to move in a direction from the third slot side wall to the fourth slot side wall. This improves assembly stability of the fixing member in the mounting slot.

In an implementation, a distance between the first end face and the third slot side wall is less than or equal to 0.1 mm, and a distance between the second end face and the fourth slot side wall is less than or equal to 0.1 mm.

It may be understood that, due to tolerance of the fixing member and the mounting slot during production or assembly, in this implementation, provided that the distance between the first end face and the third slot side wall less than or equal to 0.1 mm and the distance between the second end face and the fourth slot side wall less than or equal to 0.1 mm, it may be considered that the mounting slot has effectively limited the fixing member in the direction from the third slot side wall to the fourth slot side wall.

In an implementation, the circuit board is fixedly connected to the second slot side wall, the circuit board further includes a second limiting part, the fixing member further includes a second stop plate connected to the fixing plate, the second stop plate is located on a side of the second limiting part away from the second slot side wall, and the second stop plate faces toward the second limiting part or abuts against the second limiting part, so as to limit the second limiting part to move toward the first slot side wall. This improves assembly stability of the switch member in the mounting slot.

In an implementation, a direction from the second slot side wall to the first slot side wall is an X-axis direction of the electronic device, the second stop plate limits the second limiting part to move toward the first slot side wall, that is, limits the second limiting part to move in the X-axis direction, and that is, the fixing plate limits the second limiting part in the X-axis direction through the second stop plate. The X-axis direction is a width direction of the electronic device.

In an implementation, a distance between two faces of a second limiting plate and the second limiting part that face toward each other is less than or equal to 0.1 mm.

It may be understood that, due to tolerance of the second limiting plate and the second limiting part during production or assembly, in this implementation, provided that the distance between the two faces of the second limiting plate and the second limiting part that face toward each other less than or equal to 0.1 mm, it may be considered that the second limiting plate has effectively limited the second limiting part in the X-axis direction.

In an implementation, the second stop plate partially protrudes to form a protrusion, and the protrusion abuts against a second limited face, so as to compensate for the tolerance of the second limiting plate and the second limiting part during production or assembly. This ensures that the second limiting plate effectively limits the second limiting part in the X-axis direction.

In an implementation, the fixing member further includes a lug, where the lug is connected to the fixing plate and is bent and extends from the fixing plate in a direction leaving the first slot side wall, or the lug is connected to the first stop plate and is bent and extends from the first stop plate in a direction approaching the fixing plate. During mounting of the fixing member, the lug may be pressed to mount the fixing member in the mounting slot; in addition, during demounting of the fixing member, the lug may be lifted to take the fixing member out of the mounting slot. That is, arrangement of the lug facilitates mounting and demounting of the fixing member.

In an implementation, the circuit board is provided with a first limiting slot, the first limiting slot runs through the circuit board in a thickness direction of the circuit board, the slot bottom wall of the mounting slot partially protrudes to form a limiting block, and the limiting block is clamped in the first limiting slot, to limit the circuit board to move, so as to effectively limit the circuit board.

In an implementation, the limiting block is connected between the first slot side wall and the second slot side wall, and the limiting block is clamped in the limiting block, so as to limit the circuit board to move in the direction from the third slot side wall to the fourth slot side wall.

In an implementation, the direction from the third slot side wall to the fourth slot side wall is a Y-axis direction of the electronic device, the limiting block limits the circuit board to move in the direction from the third slot side wall to the fourth slot side wall, that is, limits the circuit board to move in the Y-axis direction, and that is, limits the circuit board in the Y-axis direction. The Y-axis direction is a length direction of the electronic device.

In an implementation, the fixing plate is provided with a second limiting slot, the second limiting slot runs through the fixing plate in a thickness direction of the fixing plate, and the limiting block is clamped in the second limiting slot, so as to limit the fixing plate to move in the direction from the third slot side wall to the fourth slot side wall, that is, limit the fixing plate in the Y-axis direction.

### BRIEF DESCRIPTION OF DRAWINGS

FIG. 1 is a schematic structural diagram of an electronic device according to an embodiment of this application;
FIG. 2 is a schematic diagram of a partial structure of the electronic device shown in FIG. 1;
FIG. 3 is a schematic structural diagram of a middle frame of the electronic device shown in FIG. 2;
FIG. 4 is a schematic structural diagram of a switch member of a button assembly shown in FIG. 2;
FIG. 5 is an exploded schematic structural diagram of the switch member shown in FIG. 4;
FIG. 6 is a schematic cross-sectional view of an internal structure of the electronic device shown in FIG. 2 in a direction A-A;
FIG. 7 is an enlarged schematic structural diagram of an area B of the structure shown in FIG. 6;
FIG. 8 is an exploded schematic structural diagram of a pressing member of a button assembly shown in FIG. 2;
FIG. 9 is a schematic cross-sectional view of an internal structure of the electronic device shown in FIG. 2 in a direction C-C;
FIG. 10 is a schematic cross-sectional view of an internal structure of the electronic device shown in FIG. 2 in a direction D-D;
FIG. 11 is a schematic structural diagram of a fixing member of a button assembly shown in FIG. 2;
FIG. 12 is a schematic cross-sectional view of an internal structure of the electronic device shown in FIG. 2 in a direction E-E;
FIG. 13 is an enlarged schematic structural diagram of an area F of the structure shown in FIG. 12;
FIG. 14 is an enlarged schematic structural diagram of an area G of the structure shown in FIG. 6;
FIG. 15 is a schematic cross-sectional view of an internal structure of the electronic device shown in FIG. 2 in a direction H-H;
FIG. 16 is a schematic cross-sectional view of an internal structure of the electronic device shown in FIG. 2 in a direction H-H according to another implementation;
FIG. 17 is a schematic cross-sectional view of an internal structure of the electronic device shown in FIG. 2 in a direction H-H according to a third implementation;
FIG. 18 is a schematic cross-sectional view of an internal structure of the electronic device shown in FIG. 2 in a direction H-H according to a fourth implementation;
FIG. 19 is a schematic cross-sectional view of an internal structure of the electronic device shown in FIG. 2 in a direction H-H according to a fifth implementation;
FIG. 20 is a schematic cross-sectional view of an internal structure of the electronic device shown in FIG. 2 in a direction I-I; and
FIG. 21 is an enlarged schematic structural diagram of an area J of the structure shown in FIG. 20.

### DESCRIPTION OF EMBODIMENTS

The following describes embodiments of this application with reference to the accompanying drawings in the embodiments of this application.

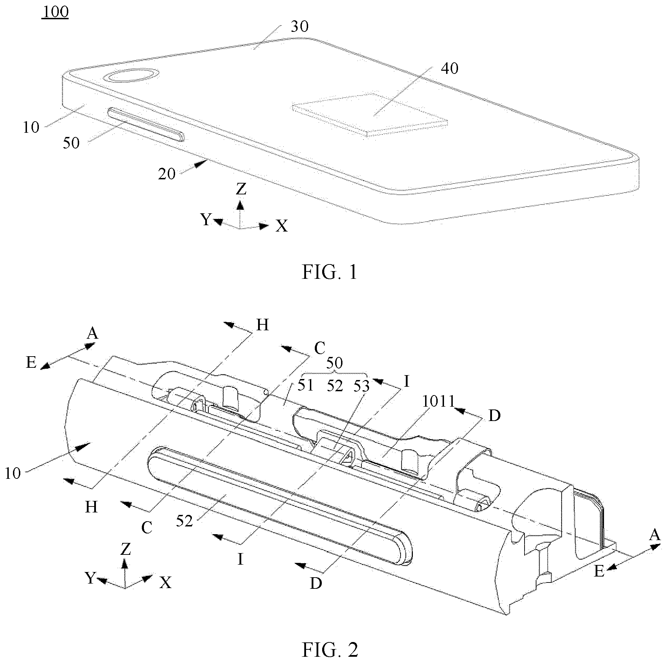

FIG. 1 is a schematic structural diagram of an electronic device 100 according to an embodiment of this application, and FIG. 2 is a schematic diagram of a partial structure of the electronic device 100 shown in FIG. 1.

The electronic device 100 may be a tablet computer, a mobile phone, a camera, a personal computer, a notebook computer, a vehicle-mounted device, a wearable device, AR (Augmented Reality, Augmented Reality) glasses, an AR helmet, VR (Virtual Reality, Virtual Reality) glasses, or a VR helmet. A mobile phone is used as an example of the electronic device 100 in the embodiment shown in FIG. 1 for description. For ease of description, as shown in FIG. 1, a width direction of the electronic device 100 is defined as an X axis. A length direction of the electronic device 100 is defined as a Y axis. A thickness direction of the electronic device 100 is defined as a Z axis.

In this embodiment, the electronic device 100 includes a middle frame 10, a screen 20, a rear cover 30, a main board 40, and a button assembly 50. The screen 20 and the rear cover 30 face toward each other and are respectively located on two sides of the middle frame 10.

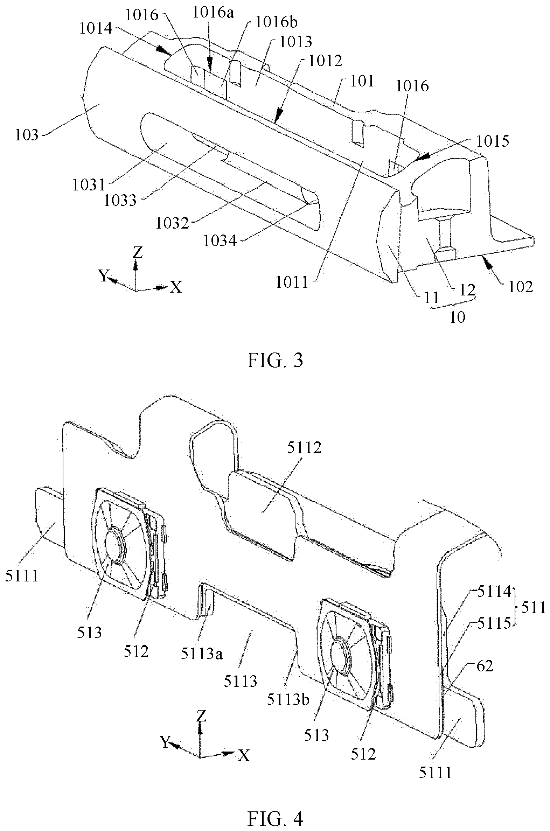

FIG. 3 is a schematic structural diagram of a middle frame 10 of the electronic device 100 shown in FIG. 2.

The middle frame 10 includes an assembly face 101, a mounting face 102 that faces away from the assembly face 101, and an external face 103 that are connected between the assembly face 101 and the mounting face 102. The middle frame 10 is provided with a mounting slot 1011 and a button slot 1031.

An opening of the mounting slot 1011 is located on the assembly face 101. The mounting slot 1011 is recessed in a direction from the assembly face 101 to the mounting face 102. Specifically, the mounting slot 1011 includes a slot side wall and a slot bottom wall (not shown in the figure). The slot side wall is located on a plane in the Z-axis direction, and the slot bottom wall is located on an X-Y plane. The slot side wall includes a first slot wall 1012 and a second slot wall 1013 that face toward each other, and a third slot wall 1014 and a fourth slot wall 1015 that are connected between the first slot wall 1012 and the second slot wall 1013. The second slot wall 1013 is a slot wall of the slot side wall away from the external face 103, and the second slot wall 1013 is partially recessed in the X-axis direction to form a clamping slot 1016. The clamping slot 1016 includes a clamping slot wall 1016a facing opposite to the assembly face 101, and a clamping slot bottom wall 1016b connected to the clamping slot wall 1016a. In an implementation, two clamping slots 1016 are provided. The two clamping slots 1016 are respectively a first clamping slot 1016 and a second clamping slot 1016, and the first clamping slot 1016 and the second clamping slot 1016 are provided at an interval in the Y-axis direction. The slot bottom wall partially protrudes to form a limiting block (not shown in the figure), and the limiting block extends in the X-axis direction and is connected between the first slot wall 1012 and the second slot wall 1013. The limiting block includes a first side face and a second side face that face away from each other. It should be understood that, the mounting slot 1011 is not limited to being strip-shaped as shown in FIG. 3 only, and may alternatively be cylindrical or cuboid.

An opening of the button slot 1031 is located on the external face 103. The button slot 1031 is recessed from the external face 103 in the X-axis direction and communicates with the mounting slot 1011. Specifically, the button slot 1031 includes a button slot bottom wall 1032, and the button slot bottom wall 1032 is partially recessed to form a first mounting hole 1033 and a second mounting hole 1034. The first mounting hole 1033 and the second mounting hole 1034 are arranged at an interval in the Y-axis direction and both communicate with the mounting slot 1011. It should be understood that, the button slot 1031 is not limited to being strip-shaped as shown in FIG. 3 only, and may alternatively be cylindrical or cuboid.

In an implementation, the middle frame 10 includes a side frame 11 and a middle plate 12. The side frame 11 may be made of a metal material. The middle plate 12 may be made of a plastic material. The middle plate 12 may be formed on the side frame 11 through an injection molding process, so as to form a whole together with the side frame 11, thereby improving overall strength of the middle plate 12 and the side frame 11.

Referring to FIG. 1, the screen 20 is mounted on the mounting face 102. The screen 20 includes a display face that faces away from the middle frame 10, where the display face is configured to display images, videos, and the like. In this embodiment, the screen 20 is a 2D (Dimensions, Dimensions) display. Certainly, in other embodiments, the screen 20 may alternatively be a 2.5D curved screen or a 3D curved screen.

In an implementation, the screen 20 includes a cover plate and a display panel fixed to the cover plate. The cover plate may be made of glass or another transparent material. The display panel may use an LED (Liquid Crystal Display, Liquid Crystal Display), an OLED (Organic Light-Emitting Diode, Organic Light-Emitting Diode) display, an AMOLED (Active-Matrix Organic Light Emitting Diode, Active-Matrix Organic Light Emitting Diode) display, a FLED (Flex Light-Emitting Diode, Flex Light-Emitting Diode) display, a Mini LED, a Micro LED, a Micro OLED, a QLED (Quantum Dot Light Emitting Diode, Quantum Dot Light Emitting Diode), or the like. In addition, the display panel may also have a touch control function, that is, the display panel is a touch display panel. In this case, the display panel is electrically connected to the main board 40. The display panel can generate a touch control signal and transmit the touch control signal to a processor on the main board 40. The processor receives the touch control signal, and controls, based on the touch control signal, an application (Application, App) in the electronic device 100 to be opened.

The rear cover 30 is located on a side of the middle frame 10 facing away from the screen 20. When a user uses the electronic device 100, the rear cover 30 faces away from the user, and the screen 20 faces toward the user. Specifically, the rear cover 30 is mounted on the assembly face 101. The rear cover 30 may be detachably mounted on the middle frame 10, so as to facilitate maintenance and replacement of a battery, a memory card or a circuit board in the electronic device 100. In this case, the rear cover 30 may be made of engineering plastic such as PC (Polycarbonate, Polycarbonate) and ABS (Acrylonitrile Butadiene Styrene copolymers, Acrylonitrile Butadiene Styrene copolymers), or metal alloy such as titanium alloy and aluminum magnesium alloy.

An accommodating space (not shown in the figure) is enclosed by the rear cover 30, the screen 20 and the middle frame 10. The accommodating space may be configured to accommodate a microphone, a loudspeaker, a battery, or another device. It may be learned from FIG. 1 that, a roughly cuboid structure is enclosed by the rear cover 30, the screen 20 and the middle frame 10.

The main board 40 is mounted in the accommodating space. A processor (not shown in the figure) and a memory (not shown in the figure) are disposed on the main board 40. The memory is configured to store computer program code. The computer program code includes a computer instruction. The processor is configured to call a computer instruction so as to enable the electronic device 100 to perform a corresponding operation.

Part of the button assembly 50 is mounted in the accommodating space, part of the button assembly 50 is mounted in the mounting slot 1011, part of the button assembly 50 is mounted in the button slot 1031, and part of the button assembly 50 is exposed relative to the middle frame 10. Specifically, the button assembly 50 is electrically connected to the main board 40. In this embodiment, the button assembly 50 may be a button for adjusting a volume. When the button assembly 50 is pressed, the button assembly 50 can generate an electric signal and transmit the electric signal to the processor on the main board 40. The processor receives the electric signal and adjusts, based on the electric signal, a volume of the electronic device 100. In other embodiments, the button assembly 50 may alternatively be a power button for waking up or turning off the screen 20, or may be another button mounted on a side face of the electronic device 100. This is not specifically limited in this application.

The button assembly 50 includes a switch member 51, a pressing member 52 and a fixing member 53. The switch member 51 is mounted in the mounting slot 1011 and electrically connected to the main board 40. Part of the pressing member 52 is mounted in the mounting slot 1011, and part of the pressing member 52 extends out of the middle frame 10. The fixing member 53 is located in the mounting slot 1011 and faces toward the switch member 51. The fixing member 53 is configured to fix and limit the switch member 51 and the pressing member 52. It should be learned that, that the switch member 51 is mounted in the mounting slot 1011 means that at least part of the switch member 51 is mounted in the mounting slot 1011.

The pressing member 52 is configured to apply acting force to the switch member 51, so as enable the switch member 51 to generate an electric signal and transmit the electric signal to the main board 40. For example, when a user presses the pressing member 52, the pressing member 52 moves toward the accommodating space. When pressure is applied to the switch member 51 through the pressing member 52, the switch member 51 generates an electric signal and transmits the electric signal to the main board.

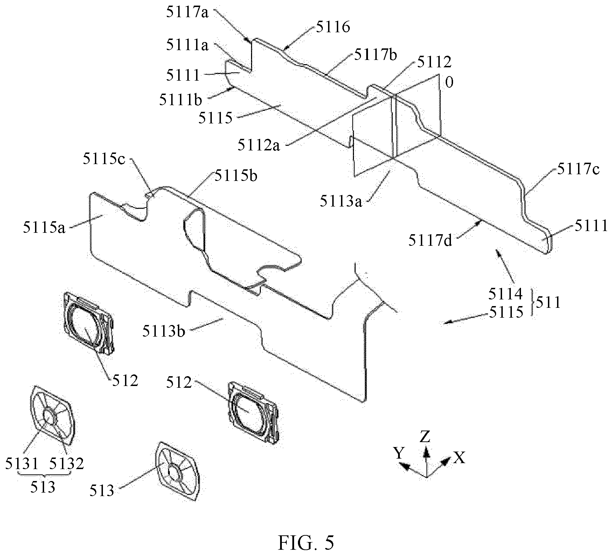

FIG. 4 is a schematic structural diagram of a switch member 51 of a button assembly 50 shown in FIG. 2, and FIG. 5 is an exploded schematic structural diagram of the switch member 51 shown in FIG. 4.

The switch member 51 includes a circuit board 511, a switch 512, and an elastic member 513. The switch 512 is fixed to the circuit board 511 and electrically connected to the circuit board 511. The elastic member 513 is mounted on a side of the switch 512 facing away from the circuit board 511.

The circuit board 511 includes a first limiting part 5111 and a second limiting part 5112. In this embodiment, two first limiting parts 5111 are provided, and the two first limiting parts 5111 are located at two ends of the circuit board 511. It should be noted that, in other embodiments, one or two or more first limiting parts 5111 may be provided. This is not specifically limited in this application.

The circuit board 511 is provided with a first limiting slot 5113, and the first limiting slot 5113 runs through the circuit board 511 in a thickness direction of the circuit board 511. Specifically, the first limiting slot 5113 includes a first limiting slot wall 5113a and a second limiting slot wall 5113b that face toward each other.

In an implementation, the circuit board 5111 includes a reinforcing plate 5114 and a flexible circuit board 5115, and part of the flexible circuit board 5112 is mounted on the reinforcing plate 5114. Specifically, the reinforcing plate 5114 is of a flat panel-shaped structure and is parallel to a Y-Z plane. The reinforcing plate 5114 includes a first mounting face 5115, a second mounting face 5116, and a peripheral face 5117. The first mounting face 5115 and the second mounting face 5116 face away from each other and are both parallel to the Y-Z plane. The peripheral face 5117 is connected between the first mounting face 5115 and the second mounting face 5116. The peripheral face 5117 includes a first peripheral face 5117a, a second peripheral face 5117b, a third peripheral face 5117c, and a fourth peripheral face 5117d that are sequentially connected.

The first peripheral face 5117a partially protrudes to form a second limiting part 5112, and the second limiting part 5112 protrudes from the first peripheral face 5117a in a forward direction of the Z axis. The second limiting part 5112 includes a second limiting face 5112a facing the same direction as the first mounting face 5115. The second limiting part 5112 is located in a middle area of the first peripheral face 5117a.

The second peripheral face 5117b partially protrudes to form one first limiting part 5111, and the first limiting part 5111 protrudes from the second peripheral face 5117b in a reverse direction of the Y axis. In this embodiment, the first limiting part 5111 is located on an edge area of the second peripheral face 5117b facing away from the first peripheral face 5117a. Specifically, the first limiting part 5111 includes a first limiting face 5111a facing the same direction as the first peripheral face 5117a and a bottom face 5111b facing away from the first limiting face 5111a.

The third peripheral face 5117c and the bottom face 5111b are located on a same surface. Specifically, the third peripheral face 5117c faces away from the first peripheral face 5117a. The third peripheral face 5117c is partially recessed to form a first secondary limiting slot 5113a, that is, the first secondary limiting slot 5113a is recessed in a direction from the third peripheral face 5117c to the first peripheral face 5117a. In this embodiment, the first secondary limiting slot 5113a is located in a middle area of the third peripheral face 5117c, and runs through the first mounting face 5115 and the second mounting face 5116.

The fourth peripheral face 5117d faces away from the second peripheral face 5117b. The fourth peripheral face 5117d partially protrudes to form another first limiting part 5111, and the first limiting part 5111 protrudes from the fourth peripheral face 5117d in a forward direction of the Y axis. In this embodiment, the first limiting part 5111 is located on an area of the fourth peripheral face 5117d facing away from the first peripheral face 5117a.

In an implementation, the reinforcing plate 5114 is of a symmetrical structure. That is, the reinforcing plate 5114 has a symmetry plane O, and the reinforcing plate 5114 is located on two sides of the symmetry plane O and symmetrical about the symmetry plane O, so as to simplify a preparation process of the reinforcing plate 5114. Specifically, the second limiting part 5112 is located right in the middle of the first peripheral face 5117a and is symmetrical about the symmetry plane O. The two first limiting parts 5111 are symmetrical about the symmetry plane O. The first secondary limiting slot 5113a is located right in the middle of the third peripheral face 5117a and is symmetrical about the symmetry plane O. The reinforcing plate 5114 is made of a metal material such as steel or a high-strength plastic material.

The flexible circuit board 5115 includes a first section 5115a, a second section 5115b, and a third section 5115c. The first section 5115a is provided with a second secondary limiting slot 5113b, and the second secondary limiting slot 5113b runs through a first end 511a in a thickness direction of the first end 511a. The first section 5115a is mounted on the first mounting face 5115 of the reinforcing plate 5114. The first limiting part 5111, the second limiting part 5112, and the first secondary limiting slot 5113a are exposed. The second secondary limiting slot 5113b and the first secondary limiting slot 5113a jointly form the first limiting slot 5113. The first section 5115a is mounted on the first mounting face 5115 through a first bonding layer 61. It may be understood that, the first section 5115a as a flexible circuit board is extremely prone to folding damage in use, and the first section 5115a mounted on the first mounting face 5115 increases mechanical strength of the first section 5115a and increases assembly and use convenience of the first section 5115a.

The second section 5115b and the first section 5115a are disposed at an interval. The second section 5115b is located on a side of the reinforcing plate 5114 away from the first section 5115a. The second section 5115b is mounted in a whole-machine inner cavity and electrically connected to the main board. The third section 5115c is connected between the first section 5115a and the second section 5115b. The third section 5115c is a bent section.

It may be understood that, the bent third section 5115c connected between the first section 5115a and the second section 5115b can not only improve mounting flexibility of the flexible circuit board 5115 to prevent the flexible circuit board 5115 from being interfered with by the middle frame 10, but also transmit, to the main board sequentially through the third section 5115c and the second section 5115b, an electric signal that is transmitted to the first section 5115a.

In this embodiment, two switches 512 are provided. The two switches 512 are both mounted on a surface of the flexible circuit board 5115 facing away from the fixing plate 5114 and electrically connected to the flexible circuit board 5115. Specifically, the two switches 512 are respectively a first switch 512 and a second switch 512. The first switch 512 and the second switch 512 are mounted on a surface of the first section 5115a facing away from the fixing plate 5114 at an interval in the Y-axis direction and both electrically connected to the first section 5115a. When the first switch 512 is triggered, an electric signal for increasing a volume is generated; and when the second switch 512 is triggered, an electric signal for decreasing a volume is generated. The electric signal generated by the triggered first switch 512 or the triggered second switch 512 is transmitted to the main board sequentially through the first section 5115a, the third section 5115c, and the second section 5115b to be used to control a volume of the electronic device 100. It should be noted that, in other embodiments, one or two or more switches 512 may be provided. This is not specifically limited in this application.

Correspondingly, two elastic members 513 are provided. The two elastic member 513 are mounted on a side of the two switches 512 facing away from the flexible circuit board 5115. In this embodiment, the two elastic members 513 are respectively a first elastic member 513 and a second elastic member 513. Specifically, the first elastic member 513 covers the first switch 512, and the second elastic member 513 covers the second switch 512. That is, the first elastic member 513 and the second elastic member 513 respectively cover the first switch 512 and the second switch 512, so as to effectively protect the first switch 512 and the second switch 512 and prevent the first switch 512 and the second switch 512 from collision damage by other parts.

In an implementation, the first elastic member 513 includes a middle part 5131 and an edge part 5132 surrounding the middle part 5131. The middle part 5131 directly faces toward the first switch 512. The edge part 5132 extends in a direction from the middle part 5131 to the first switch 512 and forms a compression space together with the middle part 5131, that is, the first elastic member 513 is substantially of a cover body structure and covers the first switch 512 within the compression space.

When pressing force is applied to the middle part 5131, the middle part 5131 moves toward the first switch 512 and drives the edge part 5132 to be bent toward the first switch 512 so as to squeeze the compression space until the middle part 5131 abuts against the first switch 512 to enable the first switch 512 to generate an electric signal. When the pressing force applied to the middle part 5131 disappears, the middle part 5131 and the edge part 5132 both restore an original state under the action of elastic force of their own, and in this case, the compression space restores an original state.

It should be understood that, the second elastic member 513 and the first elastic member 513 substantially have a same structure. Details are not described herein again.

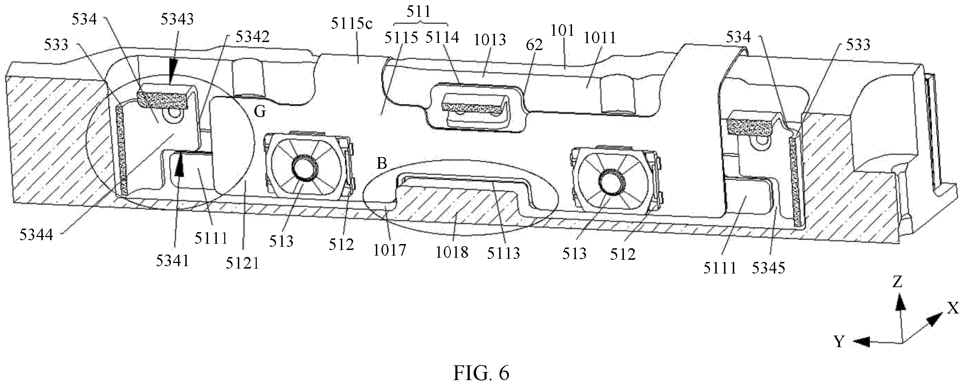

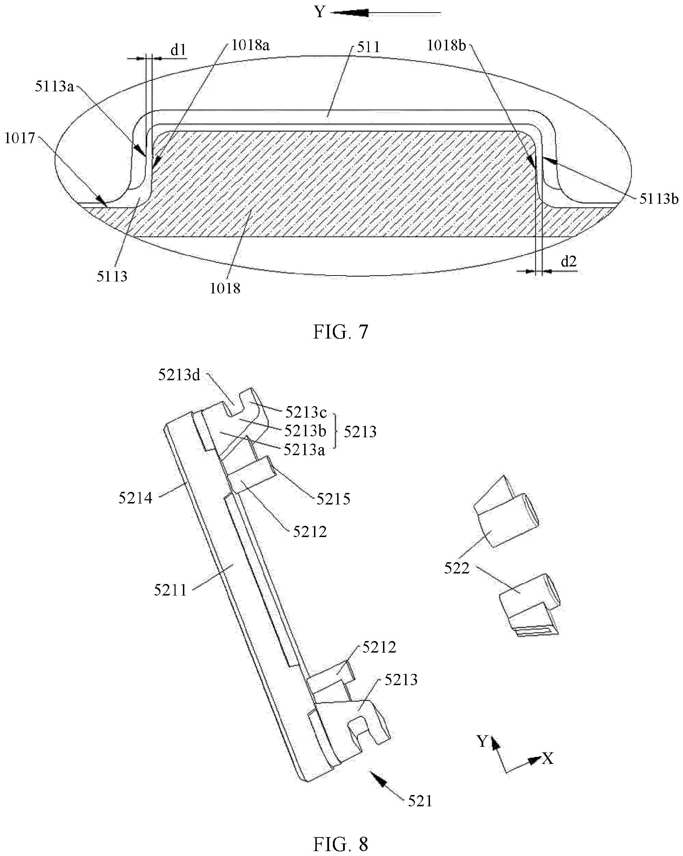

FIG. 6 is a schematic cross-sectional view of an internal structure of the electronic device 100 shown in FIG. 2 in a direction A-A, and FIG. 7 is an enlarged schematic structural diagram of an area B of the structure shown in FIG. 6.

In this embodiment, part of the circuit board 511, the first switch 512, the second switch 512, the first elastic member 513, and the second elastic member 513 are all located in the mounting slot 1011. Specifically, the circuit board 511 is fixedly connected to the second slot wall 1013. The reinforcing plate 5114 is mounted on the first slot wall 1012 through a second bonding layer 62. The first section 5115a, the first switch 512, the second switch 512, the first elastic member 513, and the second elastic member 513 are all mounted on a side of the reinforcing plate 5114 facing away from the second bonding layer 62. In this case, a limiting block 1018 on the slot bottom wall 1017 of the mounting slot 1011 is clamped in the first limiting slot 5113, so as to limit the circuit board 511 to move in the Y-axis direction and limit the circuit board 511 in the Y-axis direction. That the limiting block 1018 is clamped in the first limiting slot 5113 means that at least part of the limiting block 1018 is clamped in the first limiting slot 5113.

It should be learned that, due to tolerance of the circuit board 511 and the limiting block 1018 during production or assembly, provided that a distance d1 between the first side face 1018a of the limiting block 1018 and the first limiting slot wall 5113a less than or equal to 0.1 mm and a distance d2 between the second side face 1018b and the second limiting slot wall 5113b less than or equal to 0.1 mm, it may be considered that the circuit board 511 is effectively limited in the Y-axis direction.

The first switch 512, the second switch 512, the first elastic member 513, and the second elastic member 513 are all located on a side of the first section 5115a facing away from the reinforcing plate 5114. The third section 5115c is located on the assembly face 101. The assembly face 101 may be partially recessed to form an accommodating slot (not shown in the figure), and the accommodating slot accommodates the third section 5115c, so as to limit the third section 5115c to move in the Y-axis direction and limit the second section 5115b in the Y-axis direction. The second section is mounted in a whole-machine inner cavity and electrically connected to the main board. It should be understood that, a mounting manner of the second section in the whole-machine inner cavity is substantially the same as a mounting manner of the first section 5115a in the mounting slot 1011. Details are not described herein again.

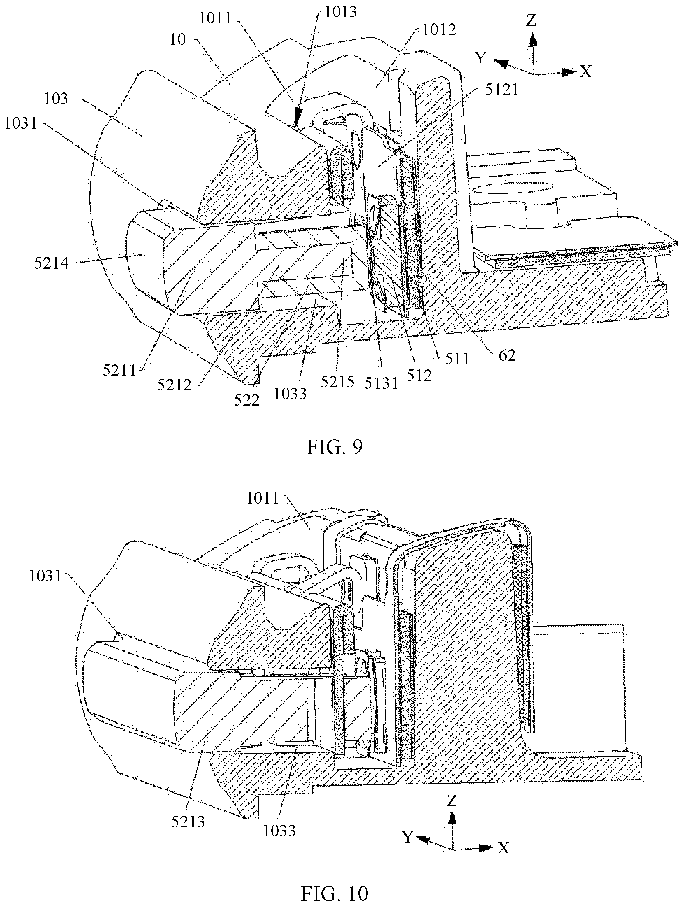

FIG. 8 is an exploded schematic structural diagram of a pressing member 52 of a button assembly 50 shown in FIG. 2, and FIG. 9 is a schematic cross-sectional view of an internal structure of the electronic device 100 shown in FIG. 2 in a direction C-C.

The pressing member 52 includes a button 521 and an elastic sleeve 522. In this embodiment, the button 521 includes a pressing part 5211, and a pushing part 5212 and a clamping part 5213 that are connected to the pressing part 5211, where the pushing part 5212 and the clamping part 5213 are located on a same side of the pressing part 5211.

The pressing part 5211 is partially exposed out of the external face 103 of the middle frame 10. Specifically, the pressing part 5211 includes a pressing end part 5214, where the pressing end part 5214 is exposed out of the external face 103 of the middle frame 10, and the rest part of the pressing part 5211 is located in the button slot 1031.

The pushing part 5212 is located on a side of the pressing part 5211 facing away from the pressing end face 5214. The pushing part 5212 extends from the button slot 1031 into the mounting slot 1011, and the pushing part 5212 faces toward the switch 512. Specifically, two pushing parts 5212 are provided. The two pushing parts 5212 are respectively a first pushing part 5212 and a second pushing part 5212. The first pushing part 5212 passes through the first mounting hole 1033 from the button slot 1031 and extends into the mounting slot 1011, and the first pushing part 5212 faces toward the first switch 512. The first pushing part 5212 includes a pushing end part 5215 away from the pressing part 5211, where the pushing end part 5215 directly faces toward the first switch 512, that is, the pushing end part 5215 directly faces toward the middle part 5131. The second pushing part 5212 and the first pushing part 5212 are arranged at an interval in the Y-axis direction. It should be understood that, an assembly manner of the second pushing part 5212 is the same as an assembly manner of the first pushing part 5212. The second pushing part 5212 passes through the second mounting hole from the button slot 1031 and extends into the mounting slot 1011, and the second pushing part 5212 faces toward the second switch 512. It should be noted that, that the pushing part 5212 faces toward the switch 512 means that at least part of the pushing part 5212 directly faces toward the first switch 512, and in this case, the pushing part 5212 can apply acting force to the switch 512.

In an implementation, the first pushing part 5212, the second pushing part 5212 and the pressing part 5211 are integrally molded. Certainly, in other implementations, the first pushing part 5212, the second pushing part 5212 and the pressing part 5211 may alternatively be fixed in a fixing manner of welding or gluing. This is not specifically limited in this application.

The elastic sleeve 522 sleeves an outer surface of the pushing part 5212. In this embodiment, two elastic sleeves 522 are provided. The two elastic sleeves 522 are respectively a first elastic sleeve 522 and a second elastic sleeve 522. Specifically, the first elastic sleeve 522 sleeves an outer surface of the pushing end part 5215 of the first pushing part 5212, and the second elastic sleeve 522 sleeves an outer surface of the pushing end part 5215 of the second pushing part 5212, so as to buffer pressure applied by the pushing part 5212 to the middle part 5131. This prevents the elastic member 513 from damage by excessively large pressure and prolongs a service life of the elastic member 513.

When a user applies external force to the pressing end part 5214, the pressing part 5211 pushes the first pushing part 5212 to move toward the middle part 5131, and in this case, the first pushing part 5212 drives the first elastic sleeve 522 to move toward the middle part 5131 until the pushing end part 5217 of the first pushing part 5213 applies acting force to the middle part 5131 through the first elastic sleeve 522, so as to enable the first switch 512 to generate an electric signal and transmit the electric signal to the main board 40. In addition, when a user withdraws the applied external force, the first switch 512 can apply external force to the middle part 5214 under the action of elastic force of its own and then apply external force to the pushing end part 5215 through the first elastic sleeve 522 to enable the first pushing part 5212 to return to an original position, so as to cut off electrical connection of the first switch 512. The first elastic sleeve 522 and the middle part 5131 may always be in a contact state, or a gap may exist between the first elastic sleeve 522 and a middle 5141. It may be understood that, a switching process of the second switch 512 is substantially the same as a switching process of the first switch 512. Details are not described herein again.

FIG. 10 is a schematic cross-sectional view of an internal structure of the electronic device 100 shown in FIG. 2 in a direction D-D.

The clamping part 5213 extends from the button slot 1031 into the mounting slot 1011. In this embodiment, two clamping parts 5213 are provided. The two clamping parts 5213 are respectively connected to two ends of the pressing part 5211. The two clamping parts 5213 are respectively a first clamping part 5213 and a second clamping part 5213. The first clamping part 5213 is located on a side of the first pushing part 5212 facing away from the second pushing part 5212 and connected to the first pushing part 5212.

The first clamping part 5213 penetrates through the first mounting hole 1033 from the button slot 1031 and extends into the mounting slot 1011. The first clamping part 5213 includes a first part 5216, a second part 5217, and a third part 5218. The first part 5216 is connected between the pressing part 5211 and the second part 5217. The second part 5217 is connected between the first part 5216 and the third part 5218. The third part 5218 extends in a direction leaving the second clamping part 5213. In this case, a clamping slot 5213d is formed among the first part 5216, the second part 5217 and the third part 5218.

The second clamping part 5213 is located on a side of the second pushing part 5212 facing away from the first pushing part 5212 and connected to the second pushing part 5212. It may be understood that, the second clamping part 5213 and the first clamping part 5213 substantially have a same structure. Details are not described herein again. The first clamping part 5213, the second clamping part 5213, and the pressing part 5211 are integrally molded. Certainly, in other embodiments, the first clamping part 5213, the second clamping part 5213 and the pressing part may alternatively be fixed in a fixing manner of welding or gluing. This is not specifically limited in this application.

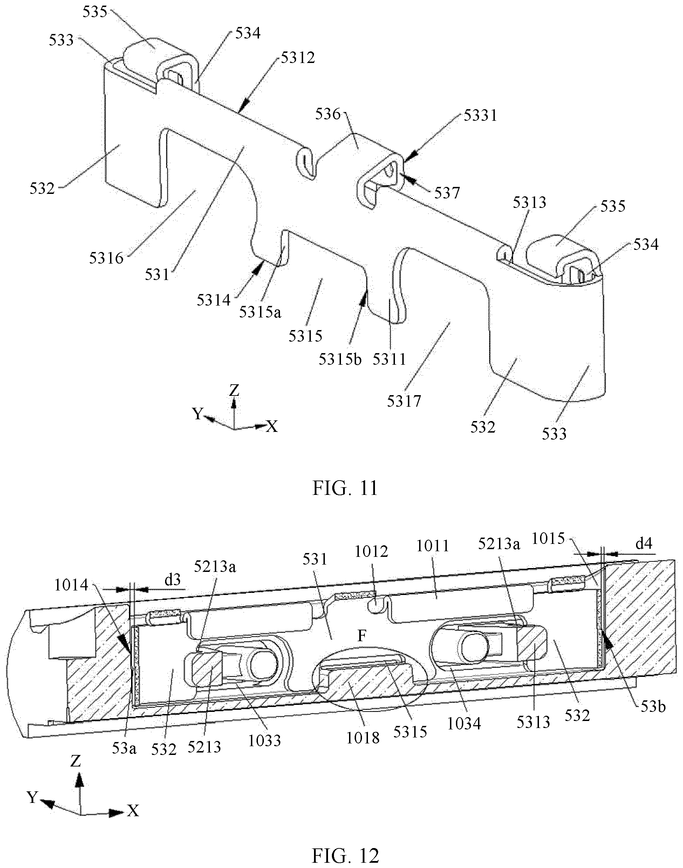

FIG. 11 is a schematic structural diagram of a fixing member 53 of a button assembly 50 shown in FIG. 2, and FIG. 12 is a schematic cross-sectional view of an internal structure of the electronic device 100 shown in FIG. 2 in a direction E-E.

The fixing member 53 includes a first end face 53a and a second end face 53b that face away from each other. The first end face 53a faces toward or abuts against the third slot side wall 1014, and the second end face 53b faces toward or abuts against the fourth slot side wall 1015, so as to limit the fixing member 53 to move in the Y-axis direction and limit the fixing member 53 in the Y-axis direction.

It should be learned that, due to tolerance of the fixing member 53 and the mounting slot 1011 during production or assembly, provided that a distance d3 between the first end face 53a of the fixing member 53 and the third slot wall 1014 of the mounting slot 1011 less than or equal to 0.1 mm and a distance d4 between the second end face 53b and the fourth slot wall 1014 of the mounting slot 1011 less than or equal to 0.1 mm, it may be considered that the fixing plate 531 is effectively limited in the Y-axis direction.

In this embodiment, the fixing member 53 includes a fixing plate 531, an engaging plate 532, a first connecting plate 533, a first stop plate 534, a lug 535, a second connecting plate 536, and a second stop plate 537.

Specifically, the fixing plate 531 is provided with a second limiting slot 5315, and the second limiting slot 5315 runs through the fixing plate 531 in a thickness direction of the fixing plate 531. The fixing plate 531 includes a first surface 5311 and a second surface 5312 that face away from each other, and an upper end face 5313 and a first lower end face 5314 that are connected between the first surface 5311 and the second surface 5312. The first surface 5311 is a surface of the fixing plate 531 facing toward the circuit board 511. That is, the second surface 5312 is a surface of the fixing plate 531 facing away from the circuit board 511. The upper end face 5313 faces away from the first lower end face 5314.

An opening of the second limiting slot 5315 is located on the first lower end face 5314 and recessed in a direction from the first lower end face 5314 to the upper end face 5315. Specifically, the opening of the second limiting slot 5315 is located in a middle area of the first lower end face 5314 and runs through the first surface 5311 and the second surface 5312. The second limiting slot 5315 includes a third limiting slot wall 5315a and a fourth limiting slot wall 5315b that face toward each other.

The engaging plate 532 is connected to the fixing plate 531. In this embodiment, two engaging plates 532 are provided. Specifically, the two engaging plates 532 are respectively a first engaging plate 532 and a second engaging plate 532. A first assembly slot 5316 is enclosed by the first engaging plate 532 and the fixing plate 531, and a second assembly slot 5317 is enclosed by the second engaging plate 632 and the fixing plate 531.

The fixing plate 531 is fixedly connected to the slot side wall. In this embodiment, the fixing plate 531 is fixedly connected to the first slot wall 1012. Specifically, the fixing plate 531 is mounted on the first slot wall 1012 through a third bonding layer (not shown in the figure), that is, the third bonding layer is connected between the second surface 5312 and the first slot wall 1012. It should be noted that, in other embodiments, the fixing plate 531 may alternatively be fixedly connected to the slot bottom wall 1017.

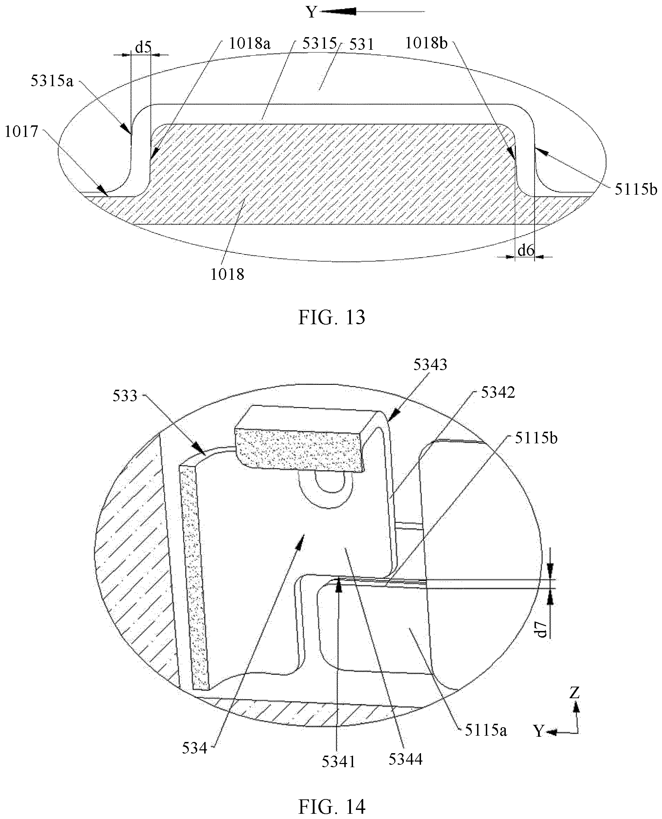

FIG. 13 is an enlarged schematic structural diagram of an area F of the structure shown in FIG. 12.

The limiting block 1018 on the slot bottom wall 1017 is clamped in the second limiting slot 5315, so as to limit the fixing plate 531 to move in the Y-axis direction and limit the fixing plate 531 in the Y-axis direction. It should be learned that, due to tolerance of the second limiting slot 5315 and the limiting block 1018 during production or assembly, provided that a distance d5 between the first side face 1018a of the limiting block 1018 and the third limiting slot wall 5315a of the second limiting slot 5315 less than or equal to 0.1 mm and a distance d6 between the second side face 1018b and the fourth limiting slot wall 5315b of the second limiting slot 5315 less than or equal to 0.1 mm, it may be considered that the fixing plate 531 is effectively limited in the Y-axis direction.

In this case, the engaging plate 532 clamps the clamping part 5313. Specifically, the first clamping part 5213 sequentially penetrates through the first mounting hole 1033 and the first assembly slot 5316 from the button slot and extends into the mounting slot 1011, the second clamping part 5213 sequentially penetrates through the second mounting hole 1034 and the second assembly slot 5317 from the button slot and extends into the mounting slot 1011, part of the first engaging plate 532 is clamped in the clamping slot 5213d of the first clamping part 5213, and part of the second engaging plate 532 is clamped in the clamping slot 5213d of the second clamping part 5213, so as to fix the pressing member 52 to the middle frame 10.

Referring to FIG. 11, the first connecting plate 533 is connected to the fixing plate 531. In this embodiment, two first connecting plates 533 are provided. The two first connecting plates 533 are respectively connected to two ends of the fixing plate 531 and are bent and extend in a direction from the fixing plate 531 to a side of the fixing plate 531 facing toward the first surface 5311. Two faces of the two first connecting plates 533 facing away from each other are respectively a first end face 53a and a second end face 53b.

The first stop plate 534 is connected to the fixing plate 531. In an implementation, the first stop plate 534 is connected to the fixing plate 531 through the first connecting plate 533, that is, the first connecting plate 533 is connected between the first stop plate 534 and the fixing plate 531. Specifically, two first stop plates 534 are provided. Each of the first stop plates 534 extends from one first connecting plate 533 to the other first connecting plate 533 and is spaced from the fixing plate 531.

Referring to FIG. 6, the first stop plate 534 is located on a side of the first limiting part 5111 away from the slot bottom wall 1017 of the mounting slot 1011, and the first stop plate 534 faces toward the first limiting part 5111 or abuts against the first limiting part 5111, so as to limit the first limiting part 5111 to move in the Z-axis direction and effectively limit the first limiting part 5111 in the Z-axis direction. That the first stop plate 534 faces toward the first limiting part 5111 or abuts against the first limiting part 5111 means that at least part of the first stop plate 534 directly faces toward the first limiting part 5111 or at least part abuts against the first limiting part 5111.

FIG. 14 is an enlarged schematic structural diagram of an area G of the structure shown in FIG. 6.

The first stop plate 534 includes a second lower end face 5341 facing the same direction as the first lower end face 5314, a side end face 5342 away from the first connecting plate 533, a third surface 5343 facing the same direction as the first surface 5311, and a fourth surface 5344 facing away from the third surface 5343.

It should be noted that, due to tolerance of the first stop plate 534 and the first limiting part 5111 during production or assembly, provided that a distance between two faces of the first stop plate 534 and the first limiting part 5111 that face toward each other less than or equal to 0.1 mm, that is, a distance d7 between the second lower end face 5341 of the first stop plate 534 and the first limiting face 5111a of the first limiting part 5111 less than or equal to 0.1 mm, it may be considered that the first stop plate 534 has effectively limited the first limiting part 5111 in the Z-axis direction.

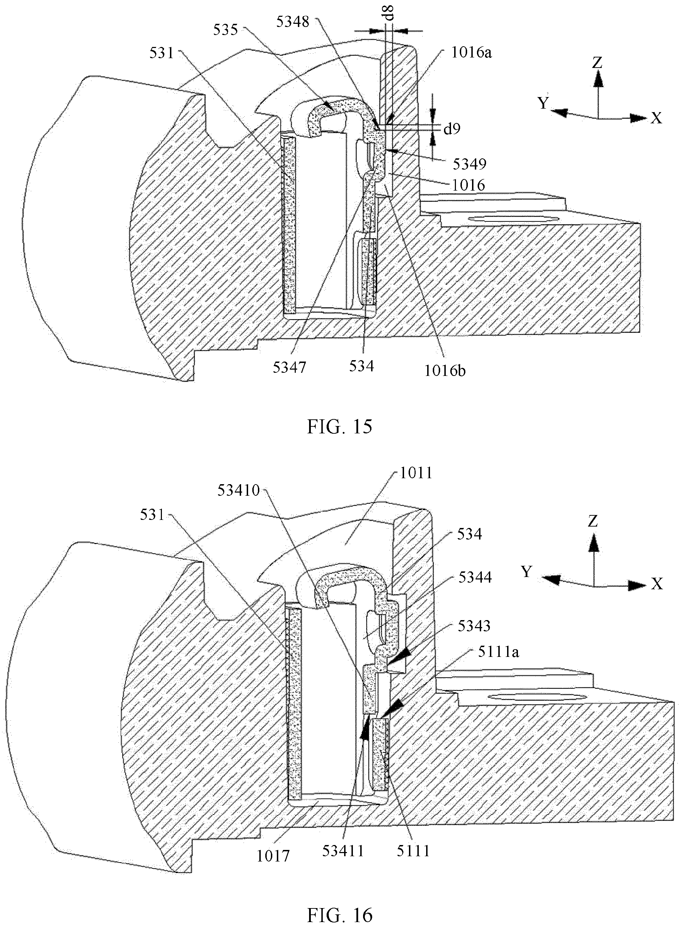

FIG. 15 is a schematic cross-sectional view of an internal structure of the electronic device 100 shown in FIG. 2 in a direction H-H.

The first stop plate 534 partially protrudes to form a clamping protrusion 5347, and the clamping protrusion 5347 is embedded in the clamping slot 1016. Specifically, the clamping protrusion 5347 protrudes in a direction from the fourth surface 5344 to the first surface 5343. The clamping protrusion 5347 includes an upper side face 5348 facing the same direction as the upper end face 5313, and a top face 5349 facing away from the fixing plate 531. The clamping protrusion 5347 is clamped in the clamping slot 1016, so as to limit the first stop plate 534 to move in the Z-axis direction, further limit the first limiting part 5111 to move in the Z-axis direction and effectively limit the first limiting part 5111 in the Z-axis direction. A distance d8 between the top face 5349 and the clamping slot bottom wall 1016b is equal to or greater than 0.05 mm.

It should be noted that, due to tolerance of the clamping protrusion 5347 and the clamping slot 1016 during production or assembly, provided that a distance d9 between the upper side face 5348 of the clamping protrusion 5347 and the clamping slot wall 1016a of the clamping slot 1016 less than or equal to 0.15 mm, the first clamping slot 1016 is considered as effectively clamping the clamping protrusion 5347 in the Z-axis direction.

In this embodiment, the two first stop plates 534 simultaneously limit the two first limiting parts 5111 to move in the Z-axis direction, that is, limit the reinforcing plate 5114 to move in the Z-axis direction, so as to effectively limit the reinforcing plate 5114 in the Z-axis direction, When the electronic device 100 is used for a long time or drops by accident, the pressing member 51 does not fall off the mounting slot 1011 easily. This ensures long-term effectiveness of the button assembly 50 and improves user experience.

In an implementation, the lug 535 is connected to the first stop plate 534. Specifically, the lug 535 is connected to an end of the first stop plate 534 facing away from the second lower end face 5341 and is bent and extends in a direction from the first stop plate 534 to the fixing plate 531. In this embodiment, two lugs 535 are provided, and the two lugs 535 are respectively connected to the two first stop plates 534, so as to facilitate mounting or demounting of the fixing member 53. During mounting of the fixing member 53, the two lugs 535 may be pressed to mount the fixing member 53 in the mounting slot 1011; and during demounting of the fixing member 53, the two lugs 535 may be lifted by using a tool such as tweezers to take the fixing member 53 out of the mounting slot 1011.

It should be noted that, in other implementations, the lug 535 may alternatively be connected to the fixing plate 531 and be bent and extend from the fixing plate 531 in a direction leaving the first slot side wall 1012. This is not specifically limited in this embodiment.

FIG. 16 is a schematic cross-sectional view of an internal structure of the electronic device 100 shown in FIG. 2 in a direction H-H according to another implementation.

The electronic device 100 shown in this implementation differs from the fixing member electronic device 100 shown in the foregoing implementation in that, the first stop plate 534 partially protrudes to form a limiting protrusion 53410, the limiting protrusion 53410 includes an end face 53411 facing toward the slot bottom wall 1017 of the mounting slot 1011, and the end face 53411 faces toward the first limiting part 5111 or abuts against the first limiting part 5111, so as to limit the first limiting part 5111 to move in the Z-axis direction and effectively limit the first limiting part 5111 in the Z-axis direction.

Specifically, the limiting protrusion 53410 protrudes in a direction from the third surface 5343 to the fourth surface 5344, so as to increase a limiting width of the first stop plate 534 capable of limiting the second limiting part 5114. When the first limiting part 5111 moves in the X-axis direction, the first stop plate 534 can still limit the first limiting part 5111 to move in the Z-axis direction, so as to effectively limit the first limiting part 5111, so that the reinforcing plate 5114 does not fall off the mounting slot 1011 easily. This improves use reliability of the button assembly 50.

Likewise, due to tolerance of the limiting protrusion 53410 and the first limiting part 5111 during production or assembly, provided that a distance between the end face 53411 and the first limiting face 5111a of the first limiting part 5111 less than or equal to 0.1 mm, it may be considered that the limiting protrusion 53410 has effectively positioned the first limiting part 5111 in the Z-axis direction.

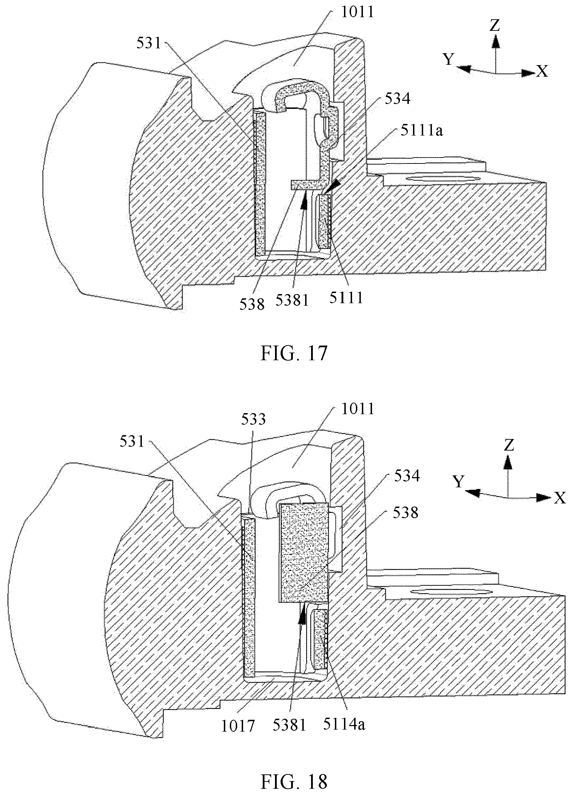

FIG. 17 is a schematic cross-sectional view of an internal structure of the electronic device 100 shown in FIG. 2 in a direction H-H according to a third implementation.

The electronic device 100 shown in this implementation differs from the electronic device 100 shown in the foregoing two implementations in that, a periphery of the first stop plate 534 is bent and extends to form a limiting plate 538. The limiting plate 538 includes a limiting face 5381 facing toward the slot bottom wall 1017 of the mounting slot 1011, and the limiting face 5381 faces toward the first limiting part 5111 or abuts against the first limiting part 5111, so as to limit the first limiting part 5111 to move in the Z-axis direction and limit the first limiting part 5111 in the Z-axis direction.

In this implementation, an end of the first stop plate 534 facing toward the slot bottom wall 1017 of the mounting slot 1011 is bent in the Y-axis direction and then extends toward the fixing plate 531 to form the limiting plate 538, so as to increase a limiting width of the first stop plate 534 capable of limiting the first limiting part 5111. When the first limiting part 5111 moves in the X-axis direction, the first stop plate 534 can still limit the first limiting part 5111 to move in the Z-axis direction, so as to effectively limit the first limiting part 5111, so that the reinforcing plate 5114 does not fall off the mounting slot 1011 easily. This improves use reliability of the button assembly 50.

Likewise, due to tolerance of the limiting plate 538 and the first limiting part 5111 during production or assembly, provided that a distance between the limiting face 5381 and the first limiting face 5114a of the first limiting part 5111 less than or equal to 0.1 mm, it may be considered that the limiting plate 538 has effectively positioned the first limiting part 5111 in the Z-axis direction.

FIG. 18 is a schematic cross-sectional view of an internal structure of the electronic device 100 shown in FIG. 2 in a direction H-H according to a fourth implementation.

The electronic device 100 shown in this implementation differs from the electronic device 100 shown in the foregoing third implementation in that, an end of the first stop plate 534 away from the first connecting plate 533 is bent in the Z-axis direction and then extends toward the fixing plate 531 to form the limiting plate 538, so as to increase a limiting width of the first stop plate 534 capable of limiting the first limiting part 5111. When the first limiting part 5111 moves in the X-axis direction, the first stop plate 534 can still limit the first limiting part 5111 to move in the Z-axis direction, so as to effectively limit the first limiting part 5111, so that the reinforcing plate 5114 does not fall off the mounting slot 1011 easily. This improves use reliability of the button assembly 50.

Likewise, due to tolerance of the limiting plate 538 and the first limiting part 5111 during production or assembly, provided that a distance between the limiting face 5381 and the first limiting face 5114a of the first limiting part 5111 less than or equal to 0.1 mm, it may be considered that the limiting plate 538 has effectively positioned the first limiting part 5111 in the Z-axis direction.

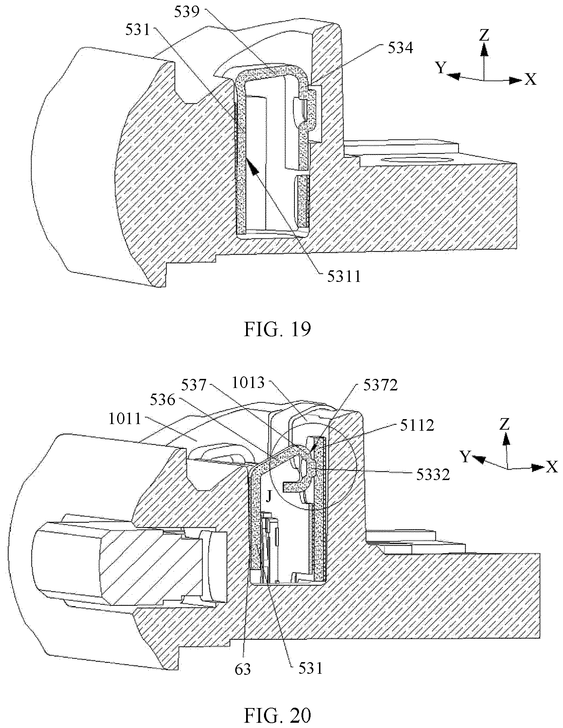

FIG. 19 is a schematic cross-sectional view of an internal structure of the electronic device 100 shown in FIG. 2 in a direction H-H according to a fifth implementation.

The electronic device 100 shown in this implementation differs from the electronic device 100 shown in the foregoing fourth implementation in that, the fixing member 53 further includes an auxiliary connecting plate 539, where the auxiliary connecting plate 539 is connected to the fixing plate 531. Specifically, two auxiliary connecting plates 539 are provided, and the two auxiliary connecting plates 539 are both connected to the upper end face of the fixing plate 531 and extend in a direction from the fixing plate 531 to a side of the fixing plate 531 facing toward the first surface 5311. Each of the auxiliary connecting plates 539 is connected between one first stop plate 534 and the fixing plate 531.

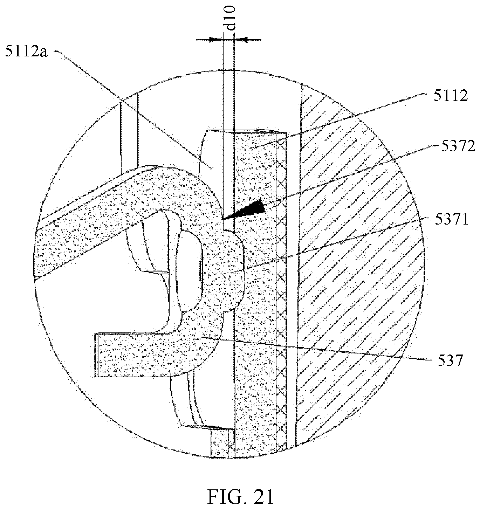

FIG. 20 is a schematic cross-sectional view of an internal structure of the electronic device 100 shown in FIG. 2 in a direction I-I, and FIG. 21 is an enlarged schematic structural diagram of an area J of the structure shown in FIG. 20.

In this embodiment, the second connecting plate 536 is connected to the fixing plate 531. Specifically, the second connecting plate 536 is connected to the upper end face 5313 of the fixing plate 531 and extends from the fixing plate 531 to the side on which the first stop plate 534 is located. The second stop plate 537 is connected to the fixing plate 531 and is spaced from and faces toward the fixing plate 531. Specifically, the second stop plate 537 is connected to the fixing plate 531 through the second connecting plate 536, that is, the second connecting plate 536 is connected between the fixing plate 531 and the second stop plate 537.

The second stop plate 537 partially protrudes to form a protrusion 5371. Specifically, the second stop plate 537 includes a fifth surface 5372 facing away from the fixing plate 531 and a sixth surface 5373 facing away from the fifth surface 5372, and the protrusion 5371 protrudes in a direction from the sixth surface 5373 to the fifth surface 5372.

The second connecting plate 536 and the second stop plate 537 are both located in the mounting slot 1011 and located on a side of the fixing plate 531 facing away from the third bonding layer 63. Specifically, the second stop plate 537 is located on a side of the second limiting part 5112 facing away from the second slot side wall 1013, and the second stop plate 537 faces toward the second limiting part 5112 or abuts against the second limiting part 5112, so as to limit the second limiting part 5112 to move in the X-axis direction, that is, limit the reinforcing plate 5114 to move in the X-axis direction and limit the reinforcing plate 5114 in the X-axis direction. The protrusion 5371 abuts against the first limiting face 5114b, to compensate for errors caused by tolerance of the second stop plate 537 and the reinforcing plate 5114 during production and assembly, so as to effectively limit the reinforcing plate 5114 in the X-axis direction.

It should be noted that, due to tolerance of the second stop plate 537 and the second limiting part 5112 during production or assembly, provided that a distance between two faces of the second stop plate 537 and the second limiting part 5112 that face toward each other less than or equal to 0.1 mm, that is, a distance d10 between the fifth surface 5372 of the second stop plate 537 and the second limiting face 5112a of the second limiting part 5112 less than or equal to 0.1 mm, it may be considered that the second stop plate 537 has effectively limited the second limiting part 5112 in the X-axis direction.

In an implementation, the fixing plate 531, the engaging plate 532, the first connecting plate 533, the first stop plate 534, the lug 535, the second connecting plate 536, and the second stop plate 537 are of an integrally molded structure. Specifically, the fixing member 53 is made of steel. The fixing member 53 may be formed with a steel plate through a stamping process. This improves overall strength of the fixing member 53.

The electronic device 100 shown in this embodiment uses the first limiting plate 533 to limit the reinforcing plate 5114 in the X-axis direction, uses the limiting block 1018 to limit the reinforcing plate 5114 in the Y-axis direction, and uses the first stop plate 534 and the third limiting plate 537 to limit the reinforcing plate 533 in the Z-axis direction. When the electronic device 100 falls off under the action of external force, the reinforcing plate 5114 limited in the three directions of X, Y and Z does not fall off the mounting slot 1011 easily to cause failure of the button assembly 50. This improves assembly stability of the button assembly 50 in the electronic device 100, ensures long-term use reliability of the button assembly, and improves user experience.

The foregoing descriptions are only specific implementations of this application, but are not intended to limit the protection scope of this application. The protection scope of this application shall be subject to the protection scope of the claims.

## Claims

1. An electronic device (100), comprising a middle frame (10), a switch member (51), a pressing member (52), and a fixing member (53), wherein the middle frame (10) comprises an external face (103) and an assembly face (101) connected to the external face (103), the middle frame (10) is provided with a mounting slot (1011) and a button slot (1031), an opening of the mounting slot (1011) is located on the assembly face (101), an opening of the button slot (1031) is located on the external face (103), and the button slot (1031) communicates with the mounting slot (1011);
the switch member (51) is mounted in the mounting slot (1011), the switch member (51) comprises a circuit board (511) and a switch (512) fixed to the circuit board (511), and the circuit board (511) comprises a first limiting part (5111); the pressing member (52) comprises a pressing part (5211), and a pushing part (5212) and a clamping part (5213) that are connected to the pressing part (5211), the pushing part (5212) and the clamping part (5213) extend from the button slot (1031) into the mounting slot (1011), the pushing part (5212) faces toward the switch (512), and the pressing part (5211) is partially exposed on the external face (103) of the middle frame (10); and the fixing member (53) is located in the mounting slot (1011), the fixing member (53) comprises a fixing plate (531), and an engaging plate (532) and a first stop plate (534) that are connected to the fixing plate (531), the fixing plate (531) is fixedly connected to a slot bottom wall and/or a slot side wall of the mounting slot (1011), the engaging plate (532) clamps the clamping part (5213), the first stop plate (534) is located on a side of the first limiting part (5111) away from the slot bottom wall of the mounting slot (1011), and the first stop plate (534) faces toward the first limiting part (5111), wherein a distance (d7) between two faces (5341, 5111a) of the first stop plate (534) and the first limiting part (5111) that face toward each other is less than or equal to 0.1 mm.

2. The electronic device (100) according to claim 1, wherein the slot side wall of the mounting slot (1011) comprises a first slot side wall (1012) and a second slot side wall (1013) that face toward each other, wherein the fixing plate (531) is fixedly connected to the first slot side wall (1012), the second slot side wall (1013) is partially recessed to form a clamping slot (1016), the first stop plate (534) partially protrudes to form a clamping protrusion (5347), and the clamping protrusion (5347) is embedded in the clamping slot (1016).

3. The electronic device (100) according to claim 1 or 2, wherein the first stop plate (534) partially protrudes to form a limiting protrusion (53410), the limiting protrusion (53410) comprises an end face (53411) facing toward the slot bottom wall of the mounting slot (1011), and the end face (53411) faces toward the first limiting part (5111) or abuts against the first limiting part (5111).

4. The electronic device (100) according to any one of claims 1 to 3, wherein a periphery of the first stop plate (534) is bent and extends to form a limiting plate (538), the limiting plate (538) comprises a limiting face (5381) facing toward the slot bottom wall of the mounting slot (1011), and the limiting face (5381) faces toward the first limiting part (5111) or abuts against the first limiting part (5111).

5. The electronic device (100) according to claim 2, wherein the slot side wall of the mounting slot (1011) comprises a third slot side wall (1014) and a fourth slot side wall (1015) that are connected to the first slot side wall (1012) and the second slot side wall (1013), the fixing member (53) comprises a first end face (53411) and a second end face (53411) that face away from each other, and the first end face (53411) faces toward or abuts against the third slot side wall (1014), and the second end face (53411) faces toward or abuts against the fourth slot side wall (1015).

6. The electronic device (100) according to claim 2 or 5, wherein the circuit board (511) is fixedly connected to the second slot side wall (1013), the circuit board (511) further comprises a second limiting part (5112), the fixing member (53) further comprises a second stop plate (537) connected to the fixing plate (531), the second stop plate (537) is located on a side of the second limiting part (5112) away from the second slot side wall (1013), and the second stop plate (537) faces toward the second limiting part (5112) or abuts against the second limiting part (5112).

7. The electronic device (100) according to claim 6, wherein the second stop plate (537) partially protrudes to form a protrusion (5371), and the protrusion (5371) abuts against the second limiting part (5112).

8. The electronic device (100) according to claim 2, wherein the fixing member (53) further comprises a lug (535), wherein the lug (535) is connected to the fixing plate (531) and is bent and extends from the fixing plate (531) in a direction leaving the first slot side wall (1012), or the lug (535) is connected to the first stop plate (534) and is bent and extends from the first stop plate (534) in a direction approaching the fixing plate (531).

9. The electronic device (100) according to claim 1, wherein the circuit board (511) is provided with a first limiting slot (5113), the first limiting slot (5113) runs through the circuit board (511) in a thickness direction of the circuit board (511), the slot bottom wall of the mounting slot (1011) partially protrudes to form a limiting block (1018), and the limiting block (1018) is clamped in the first limiting slot (5113).

10. The electronic device (100) according to claim 9, wherein the fixing plate (531) is provided with a second limiting slot (5315), the second limiting slot (5315) runs through the fixing plate (531) in a thickness direction of the fixing plate (531), and the limiting block (1018) is clamped in the second limiting slot (5315).

11. The electronic device (100) according to claim 5, wherein a distance between the first end face (53411) and the third slot side wall (1014) is less than or equal to 0.1 mm, and a distance between the second end face (53411) and the fourth slot side wall (1015) is less than or equal to 0.1 mm.

12. The electronic device (100) according to claim 6, wherein a distance between two faces of the second stop plate (537) and the second limiting part (5112) that face toward each other is less than or equal to 0.1 mm.

## Patentansprüche

1. Elektronische Vorrichtung (100), umfassend einen mittleren Rahmen (10), ein Schaltelement (51), ein Druckelement (52) und ein Befestigungselement (53), wobei der mittlere Rahmen (10) eine Außenfläche (103) und eine mit der Außenfläche (103) zusammengefügte Verbindungsfläche (101) umfasst, wobei der mittlere Rahmen (10) mit einem Montageschlitz (1011) und einem Knopfschlitz (1031) versehen ist, wobei sich eine Öffnung des Montageschlitzes (1011) an der Verbindungsfläche (101) befindet, eine Öffnung des Knopfschlitzes (1031) sich an der Außenfläche (103) befindet und der Knopfschlitz (1031) mit dem Montageschlitz (1011) in Verbindung steht;
das Schaltelement (51) in dem Montageschlitz (1011) montiert ist, das Schaltelement (51) eine Leiterplatte (511) und einen Schalter (512), der an der Leiterplatte (511) befestigt ist, umfasst und die Leiterplatte (511) ein erstes Begrenzungsteil (5111) umfasst; das Druckelement (52) ein Druckteil (5211) und ein Schiebeteil (5212) und ein Klemmteil (5213) umfasst, die mit dem Druckteil (5211) zusammengefügt sind, wobei das Schiebeteil (5212) und das Klemmteil (5213) sich von dem Knopfschlitz (1031) in den Montageschlitz (1011) erstrecken, wobei das Schiebeteil (5212) in Richtung des Schalters (512) zugewandt ist und das Druckteil (5211) teilweise auf der Außenfläche (103) des mittleren Rahmens (10) freiliegt; und das Befestigungselement (53) sich in dem Montageschlitz (1011) befindet, wobei das Befestigungselement (53) eine Befestigungsplatte (531) und eine Eingriffsplatte (532) und eine erste Anschlagplatte (534) umfasst, die mit der Befestigungsplatte (531) zusammengefügt sind, wobei die Befestigungsplatte (531) mit einer Schlitzbodenwand und/oder einer Schlitzseitenwand des Montageschlitzes (1011) fest zusammengefügt ist, wobei die Eingriffsplatte (532) das Klemmteil (5213) klemmt, die erste Anschlagplatte (534) sich auf einer Seite des ersten Begrenzungsteils (5111) von der Schlitzbodenwand des Montageschlitzes (1011) entfernt befindet und die erste Anschlagplatte (534) in Richtung des ersten Begrenzungsteils (5111) zugewandt ist, wobei ein Abstand (d7) zwischen zwei Flächen (5341, 5111a) der ersten Anschlagplatte (534) und dem ersten Begrenzungsteil (5111), die einander zugewandt sind, kleiner als oder gleich 0,1 mm ist.

2. Elektronische Vorrichtung (100) nach Anspruch 1, wobei die Schlitzseitenwand des Montageschlitzes (1011) eine erste Schlitzseitenwand (1012) und eine zweite Schlitzseitenwand (1013) umfasst, die einander zugewandt sind, wobei die Befestigungsplatte (531) mit der ersten Schlitzseitenwand (1012) fest zusammengefügt ist, die zweite Schlitzseitenwand (1013) teilweise zurückgesetzt ist, um einen Klemmschlitz (1016) auszubilden, wobei die erste Anschlagplatte (534) teilweise vorsteht, um einen Klemmvorsprung (5347) auszubilden, und der Klemmvorsprung (5347) in den Klemmschlitz (1016) eingebettet ist.

3. Elektronische Vorrichtung (100) nach Anspruch 1 oder 2, wobei die erste Anschlagplatte (534) teilweise vorsteht, um einen Begrenzungsvorsprung (53410) auszubilden, wobei der Begrenzungsvorsprung (53410) eine Stirnfläche (53411) umfasst, die in Richtung der Schlitzbodenwand des Montageschlitzes (1011) zugewandt ist, und die Stirnfläche (53411) in Richtung des ersten Begrenzungsteils (5111) zugewandt ist oder an dem ersten Begrenzungsteil (5111) anliegt.

4. Elektronische Vorrichtung (100) nach einem der Ansprüche 1 bis 3, wobei ein Umfang der ersten Anschlagplatte (534) gebogen ist und sich erstreckt, um eine Begrenzungsplatte (538) auszubilden, wobei die Begrenzungsplatte (538) eine Begrenzungsfläche (5381) umfasst, die in Richtung der Schlitzbodenwand des Montageschlitzes (1011) zugewandt ist, und die Begrenzungsfläche (5381) in Richtung des ersten Begrenzungsteils (5111) zugewandt ist oder an dem ersten Begrenzungsteil (5111) anliegt.

5. Elektronische Vorrichtung (100) nach Anspruch 2, wobei die Schlitzseitenwand des Montageschlitzes (1011) eine dritte Schlitzseitenwand (1014) und eine vierte Schlitzseitenwand (1015) umfasst, die mit der ersten Schlitzseitenwand (1012) und der zweiten Schlitzseitenwand (1013) zusammengefügt sind, wobei das Befestigungselement (53) eine erste Stirnfläche (53411) und eine zweite Stirnfläche (53411) umfasst, die voneinander abgewandt sind, und die erste Stirnfläche (53411) in Richtung der dritten Schlitzseitenwand (1014) zugewandt ist oder an dieser anliegt und die zweite Stirnfläche (53411) in Richtung der vierten Schlitzseitenwand (1015) zugewandt ist oder an dieser anliegt.

6. Elektronische Vorrichtung (100) nach Anspruch 2 oder 5, wobei die Leiterplatte (511) mit der zweiten Schlitzseitenwand (1013) fest zusammengefügt ist, wobei die Leiterplatte (511) ferner ein zweites Begrenzungsteil (5112) umfasst, wobei das Befestigungselement (53) ferner eine zweite Anschlagplatte (537) umfasst, die mit der Befestigungsplatte (531) zusammengefügt ist, wobei die zweite Anschlagplatte (537) sich auf einer Seite des zweiten Begrenzungsteils (5112) von der zweiten Schlitzseitenwand (1013) entfernt befindet und die zweite Anschlagplatte (537) in Richtung des zweiten Begrenzungsteils (5112) zugewandt ist oder an dem zweiten Begrenzungsteil (5112) anliegt.

7. Elektronische Vorrichtung (100) nach Anspruch 6, wobei die zweite Anschlagplatte (537) teilweise vorsteht, um einen Vorsprung (5371) auszubilden, und der Vorsprung (5371) an dem zweiten Begrenzungsteil (5112) anliegt.

8. Elektronische Vorrichtung (100) nach Anspruch 2, wobei das Befestigungselement (53) ferner einen Ansatz (535) umfasst, wobei der Ansatz (535) mit der Befestigungsplatte (531) zusammengefügt ist und gebogen ist und sich von der Befestigungsplatte (531) in einer Richtung erstreckt, die die erste Schlitzseitenwand (1012) verlässt, oder der Ansatz (535) mit der ersten Anschlagplatte (534) zusammengefügt ist und gebogen ist und sich von der ersten Anschlagplatte (534) in einer Richtung erstreckt, die sich der Befestigungsplatte (531) nähert.

9. Elektronische Vorrichtung (100) nach Anspruch 1, wobei die Leiterplatte (511) mit einem ersten Begrenzungsschlitz (5113) versehen ist, wobei der erste Begrenzungsschlitz (5113) durch die Leiterplatte (511) in einer Dickenrichtung der Leiterplatte (511) verläuft, die Schlitzbodenwand des Montageschlitzes (1011) teilweise hervorsteht, um einen Begrenzungsblock (1018) auszubilden, und der Begrenzungsblock (1018) in dem ersten Begrenzungsschlitz (5113) eingeklemmt ist.

10. Elektronische Vorrichtung (100) nach Anspruch 9, wobei die Befestigungsplatte (531) mit einem zweiten Begrenzungsschlitz (5315) versehen ist, wobei der zweite Begrenzungsschlitz (5315) in einer Dickenrichtung der Befestigungsplatte (531) durch die Befestigungsplatte (531) verläuft und der Begrenzungsblock (1018) in dem zweiten Begrenzungsschlitz (5315) eingeklemmt ist.

11. Elektronische Vorrichtung (100) nach Anspruch 5, wobei ein Abstand zwischen der ersten Stirnfläche (53411) und der dritten Schlitzseitenwand (1014) kleiner als oder gleich 0,1 mm ist und ein Abstand zwischen der zweiten Stirnfläche (53411) und der vierten Schlitzseitenwand (1015) kleiner als oder gleich 0,1 mm ist.

12. Elektronische Vorrichtung (100) nach Anspruch 6, wobei ein Abstand zwischen zwei Flächen der zweiten Anschlagplatte (537) und dem zweiten Begrenzungsteil (5112), die einander zugewandt sind, kleiner als oder gleich 0,1 mm ist.

## Revendications

1. Dispositif électronique (100), comprenant un cadre central (10), un élément commutateur (51), un élément de pression (52) et un élément de fixation (53), dans lequel le cadre central (10) comprend une face externe (103) et une face d'assemblage (101) reliée à la face externe (103), le cadre central (10) est pourvu d'une fente de montage (1011) et d'une fente de bouton (1031), une ouverture de la fente de montage (1011) est située sur la face d'assemblage (101), une ouverture de la fente de bouton (1031) est située sur la face externe (103), et la fente de bouton (1031) communique avec la fente de montage (1011) ;
l'élément commutateur (51) est monté dans la fente de montage (1011), l'élément commutateur (51) comprend une carte de circuit imprimé (511) et un commutateur (512) fixé à la carte de circuit imprimé (511), et la carte de circuit imprimé (511) comprend une première partie de limitation (5111) ; l'élément de pression (52) comprend une partie de pression (5211), et une partie de poussée (5212) et une partie de serrage (5213) qui sont reliées à la partie de pression (5211), à la partie de poussée (5212) et à la partie de serrage (5213) s'étendant de la fente de bouton (1031) dans la fente de montage (1011), la partie de poussée (5212) fait face au commutateur (512), et la partie de pression (5211) est partiellement exposée sur la face externe (103) du cadre central (10) ; et l'élément de fixation (53) est situé dans la fente de montage (1011), l'élément de fixation (53) comprend une plaque de fixation (531), et une plaque de mise en prise (532) et une première plaque d'arrêt (534) qui sont reliées à la plaque de fixation (531), la plaque de fixation (531) est reliée de manière fixe à une paroi inférieure de fente et/ou une paroi latérale de fente de la fente de montage (1011), la plaque de mise en prise (532) serre la partie de serrage (5213), la première plaque d'arrêt (534) est située sur un côté de la première partie de limitation (5111) à l'écart de la paroi inférieure de fente de la fente de montage (1011), et la première plaque d'arrêt (534) fait face à la première partie de limitation (5111), dans lequel une distance (d7) entre deux faces (5341, 5111a) de la première plaque d'arrêt (534) et la première partie de limitation (5111) qui se font face l'une l'autre est inférieure ou égale à 0,1 mm.

2. Dispositif électronique (100) selon la revendication 1, dans lequel la paroi latérale de fente de la fente de montage (1011) comprend une première paroi latérale de fente (1012) et une deuxième paroi latérale de fente (1013) qui se font face l'une l'autre, dans lequel la plaque de fixation (531) est reliée de manière fixe à la première paroi latérale de fente (1012), la deuxième paroi latérale de fente (1013) est partiellement évidée pour former une fente de serrage (1016), la première plaque d'arrêt (534) fait partiellement saillie pour former une saillie de serrage (5347), et la saillie de serrage (5347) est encastrée dans la fente de serrage (1016).

3. Dispositif électronique (100) selon la revendication 1 ou 2, dans lequel la première plaque d'arrêt (534) fait partiellement saillie pour former une saillie de limitation (53410), la saillie de limitation (53410) comprend une face d'extrémité (53411) faisant face à la paroi inférieure de fente de la fente de montage (1011), et la face d'extrémité (53411) fait face à la première partie de limitation (5111) ou vient en butée contre la première partie de limitation (5111).

4. Dispositif électronique (100) selon l'une quelconque des revendications 1 à 3, dans lequel une périphérie de la première plaque d'arrêt (534) est pliée et s'étend pour former une plaque de limitation (538), la plaque de limitation (538) comprend une face de limitation (5381) faisant face à la paroi inférieure de fente de la fente de montage (1011), et la face de limitation (5381) fait face à la première partie de limitation (5111) ou vient en butée contre la première partie de limitation (5111).

5. Dispositif électronique (100) selon la revendication 2, dans lequel la paroi latérale de fente de la fente de montage (1011) comprend une troisième paroi latérale de fente (1014) et une quatrième paroi latérale de fente (1015) qui sont reliées à la première paroi latérale de fente (1012) et la deuxième paroi latérale de fente (1013), l'élément de fixation (53) comprend une première face d'extrémité (53411) et une seconde face d'extrémité (53411) qui sont tournées à l'opposé l'une de l'autre, et la première face d'extrémité (53411) fait face à ou vient en butée contre la troisième paroi latérale de fente (1014), et la seconde face d'extrémité (53411) fait face à ou vient en butée contre la quatrième paroi latérale de fente (1015).

6. Dispositif électronique (100) selon la revendication 2 ou 5, dans lequel la carte de circuit imprimé (511) est reliée de manière fixe à la deuxième paroi latérale de fente (1013), la carte de circuit imprimé (511) comprend en outre une seconde partie de limitation (5112), l'élément de fixation (53) comprend en outre une seconde plaque d'arrêt (537) reliée à la plaque de fixation (531), la seconde plaque d'arrêt (537) est située sur un côté de la seconde partie de limitation (5112) à l'écart de la deuxième paroi latérale de fente (1013), et la seconde plaque d'arrêt (537) fait face à la seconde partie de limitation (5112) ou vient en butée contre la seconde partie de limitation (5112).

7. Dispositif électronique (100) selon la revendication 6, dans lequel la seconde plaque d'arrêt (537) fait partie partiellement de manière à former une saillie (5371), et la saillie (5371) vient en butée contre la seconde partie de limitation (5112).

8. Dispositif électronique (100) selon la revendication 2, dans lequel l'élément de fixation (53) comprend en outre une patte (535), dans lequel la patte (535) est reliée à la plaque de fixation (531) et est pliée et s'étend à partir de la plaque de fixation (531) dans une direction s'éloignant de la première paroi latérale de fente (1012), ou la patte (535) est reliée à la première plaque d'arrêt (534) et est pliée et s'étend à partir de la première plaque d'arrêt (534) dans une direction s'approchant de la plaque de fixation (531).

9. Dispositif électronique (100) selon la revendication 1, dans lequel la carte de circuit imprimé (511) est pourvue d'une première fente de limitation (5113), la première fente de limitation (5113) s'étend à travers la carte de circuit imprimé (511) dans le sens de l'épaisseur de la carte de circuit imprimé (511), la paroi inférieure de fente de la fente de montage (1011) fait partiellement saillie pour former un bloc de limitation (1018), et le bloc de limitation (1018) est serré dans la première fente de limitation (5113).

10. Dispositif électronique (100) selon la revendication 9, dans lequel la plaque de fixation (531) est pourvue d'une seconde fente de limitation (5315), la seconde fente de limitation (5315) s'étend à travers la plaque de fixation (531) dans le sens de l'épaisseur de la plaque de fixation (531), et le bloc de limitation (1018) est serré dans la seconde fente de limitation (5315).

11. Dispositif électronique (100) selon la revendication 5, dans lequel une distance entre la première face d'extrémité (53411) et la troisième paroi latérale de fente (1014) est inférieure ou égale à 0,1 mm, et une distance entre la seconde face d'extrémité (53411) et la quatrième paroi latérale de fente (1015) est inférieure ou égale à 0,1 mm.

12. Dispositif électronique (100) selon la revendication 6, dans lequel une distance entre deux faces de la seconde plaque d'arrêt (537) et la seconde partie de limitation (5112) qui se font face l'une l'autre est inférieure ou égale à 0,1 mm.
